# EUROPEAN PATENT APPLICATION

(11) **EP 4 498 401 A2**
(43) Date of publication of application: **29.01.2025**
(21) Application number: 24191034.8
(22) Date of filing: 26.07.2024
(51) Int. Cl.: H01J 37/20, H01J 37/28, H01J 37/30

(54) **DYNAMIC POTENTIAL ADJUSTMENT**

(30) Priority: 28.07.2023 DE 102023207263
(71) Applicant: Carl Zeiss SMT GmbH, 73447 Oberkochen (DE)
(72) Inventor: RHINOW, Daniel, 64380 Roßdorf (DE); EYHUSEN, Soeren, 64380 Roßdorf (DE)
(74) Representative: Bardehle Pagenberg Partnerschaft mbB Patentanwälte Rechtsanwälte

(57) **Abstract**

The present disclosure relates to a method for processing and/or examining a sample (100) using a particle beam (E), including the following steps: determining an electrostatic charge state of the sample (100); applying a voltage to an element (H) in surroundings of the sample, based at least in part on the determined electrostatic charge state; wherein the element (H) comprises two or more segments; and/or wherein the element (H) is movable relative to the sample (100).

The disclosure also relates to a corresponding computer program and a device.

## Description

The present patent application claims the priority of the German patent application DE 10 2023 207 263.7 entitled "DYNAMISCHE POTENTIALANPASSUNG", filed on July 28, 2023 at the German Patent and Trade Mark Office. The German patent application is incorporated by reference in its entirety into the present patent application.

### 1. Technical field

The present invention relates to a method for processing and/or examining a sample using a particle beam and to a corresponding computer program and a device.

### 2. Technical background

Processing and/or examining a sample using a particle beam is well established. For example, the particle beam may comprise an electron beam, ion beam and/or photon beam which is provided in a defined manner on the sample for the purpose of examining and/or processing the sample. The provision of the particle beam particles on the sample allows various interactions to be generated, which can enable various processing processes and/or examinations of the sample. Thus, a particle beam-based processing and/or examination of a sample may comprise very different methods.

For example, the particle beam-based processing may comprise a particle beam-induced etching and/or deposition, within the scope of which material of a sample is removed or generated locally. For example, this may comprise an electron beam-induced etching and/or deposition. Further, a defined photon irradiation of the sample may also be required for the purpose of processing the sample, for example (e.g. in the case of a laser-induced reaction). Examining a sample using a particle beam may for example comprise an image of the sample being recorded with the aid of the particle beam particles (e.g. as occurs with the aid of an electron beam in the case of a scanning electron microscope).

A particle beam-based processing and/or examination of a sample using a particle beam is now used in industry for different applications.

For example, in the semiconductor industry, increasingly smaller structures are produced on a wafer in order to ensure an increase in integration density. Among the methods used here for the production of the structures are lithography methods which image these structures on the wafer. The lithography methods may include, for example, photolithography, ultraviolet (UV) lithography, DUV lithography (i.e. lithography in the deep ultraviolet spectral region), EUV lithography (i.e. lithography in the extreme ultraviolet spectral region), x-ray lithography, nanoimprint lithography, etc. Masks are usually used here as lithography objects (e.g. photomasks, exposure masks, reticles, stamps in the case of nanoimprint lithography, etc.), which comprise a pattern in order to image the desired structures onto a wafer, for example.

As the integration density increases, so do the demands in respect of the mask production (e.g. as a result of the accompanying reduction in the structure dimensions on the mask or as a result of the greater material requirements in lithography). Thus, mask production processes are becoming ever more complex, time-consuming and expensive. It is not always possible to avoid mask errors (e.g. defects). Thus, the mask errors are usually repaired by way of particle beam-based processing since they can only be repaired e.g. in particle beam-based fashion on account of their small dimensions.

Further, it may be necessary to examine samples using a particle beam, for example in the semiconductor industry. For example, the repair of mask errors described herein may require image recordings of the mask errors or the repair location to be made using a particle beam (e.g. for a high-resolution scanning electron microscope image).

Other industrial purposes may also require processing and/or an examination of a sample using a particle beam. For example, this may be carried out for the analysis (e.g. a defect analysis) of a sample which may comprise e.g. a microchip, a wafer, a biological sample, etc.

However, the samples to be processed and/or examined using the particle beam may have an (unwanted) electrostatic charge state. For example, the (unwanted) electrostatic charge state may be delimited locally on the sample. However, the (unwanted) electrostatic charge state might also be present e.g. over the entire sample.

Unwanted effects may be caused by the (unwanted) electrostatic charge state. For example, the (unwanted) electrostatic charge state might undesirably adversely affect the properties of the particle beam incident on the sample. For example, the (unwanted) electrostatic charge state may lead to the particle beam being undesirably deflected away from the intended point of incidence on the sample. Further, the electrostatic charge state may result e.g. in a particle beam-based reaction not achieving the desired effect. Thus, the (unwanted) electrostatic charge state may cause the inability to always optimally ensure the defined processing and/or examination of the sample.

Thus, a defined processing and/or examination of the sample using a particle beam usually requires a technical workaround for the effects caused by the electrostatic charge state of the sample.

Thus, there is the need for an improvement of the processing and/or examination of samples using a particle beam.

### 3. Summary of the invention

This need is at least partly covered by the various aspects described herein.

A first aspect relates to a method for processing and/or examining a sample using a particle beam, including the following steps: determining an electrostatic charge state of the sample; applying a voltage to an element in surroundings of the sample, based at least in part on the determined electrostatic charge state.

Thus, on the one hand, the electrostatic charge state of the sample can be actively determined during processing and/or an examination of the sample. For example, the electrostatic charge state of the sample can be determined on the basis of reference structures analysed using the particle beam. For example, the electrostatic charge state can be determined on the basis of one or more reference structures (e.g. drift markers) which are situated on the sample. In an example, the method also comprises a creation of reference structures for determining the electrostatic charge state of the sample. Using a reference position of the one or more reference structures as a basis, it is for example possible to determine an electrostatic charge state of the sample using the current position of the one or more reference structures. Drift markers, which are used as reference structures, may have been deposited on the sample for the purpose of correcting a particle beam drift, for example. Further, all other ways of determining an electrostatic charge state of the sample are also conceivable (e.g. by way of different types of reference structures, by measuring the charge state and/or by analysing an image recording using the particle beam, etc.).

On the other hand, this information (i.e. the determined electrostatic charge state) can be used to apply an appropriate voltage to an element in the surroundings of the sample. The voltage applied to the element can be chosen e.g. such that this influences the processing and/or examination of the sample using the particle beam.

For example, the voltage might be chosen such that a charging effect which acts on the particle beam as a result of the determined electrostatic charge state can be purposefully addressed when processing and/or examining the sample using the particle beam.

For example, for processing and/or examining the sample, the particle beam can be directed at the sample with a defined set of one or more particle beam properties. For example, the set may comprise one or more usual particle beam properties which are set during the processing and/or examination. For example, a particle beam property may comprise a landing energy of the particle beam particles on the sample, an incidence position of the particle beam particles on the sample, a particle beam current, a particle beam acceleration, a focusing of the particle beam, and/or other types of particle beam properties. The set of one or more particle beam properties may also cause e.g. corresponding properties of the particles released by the particle beam provided on the sample during processing and/or the examination. Herein, these particles may also be referred to as released particles. For example, a property of the particles released by the particle beam can be set by way of the set of particle beam properties.

However, the defined set of particle beam properties and/or a property of the released particles may be influenced by the presence of the electrostatic charge state of the sample. For example, the electrostatic charge state of the sample may cause an electric field which emanates from the sample, wherein this electric field might interact with the particle beam particles and/or with the released particles.

For example, as a result of the electric field due to the electrostatic charge state, a particle beam property present may deviate from the particle beam property set. For example, the electric field may (locally) accelerate or decelerate the particles in the region of their point of incidence on the sample. For example, the electric field might also inadvertently deflect the particle beam. Thus, for exmaple, the particle beam might not be incident at the set target position on the sample, but at a different location instead, on account of the electrostatic charge state.

The electrostatic charge state electric field may also interact with the released particles, for example. For example, the released particles might also be (locally) accelerated or decelerated by the electrostatic charge state electric field.

It is also conceivable that the electrostatic charge state electric field might cause an (e.g. unwanted) interaction with a particle beam-induced reaction, for which the particle beam is provided on the sample for processing purposes (e.g. for particle beam-induced etching and/or deposition of e.g. excess or missing sample material).

In an example the method may comprise: provision of a gas for removing a sample material and/or depositing a material on the sample using the particle beam. Processing the sample using the particle beam as described herein may comprise e.g. a particle beam-induced removal (e.g. an etching reaction) and/or a particle beam-induced deposition (e.g. deposition reaction) using an appropriate gas (e.g. an etching gas or a deposition gas). The provision of gas for removing and/or depositing material may incorporate an application of a voltage to the element, based at least in part on the determined electrostatic charge state (as described herein).

Thus, the electrostatic charge state of the sample may give rise to charging effects which cause the processing and/or examination of the sample to be implemented very differently in comparison to what was actually set (or expected). By contrast, the method described herein can allow the electrostatic charge state present to be taken into account, and addressed by way of the element, during the processing and/or examination using the particle beam.

Thus, in general, the application of voltage to the element on the basis of the determined electrostatic charge state can create a further degree of freedom when processing and/or examining samples using a particle beam.

For example, the aforementioned approach can be understood qualitatively. The voltage at the element can be chosen, e.g. in view of the determined electrostatic charge state, such that the processing and/or examination of the sample can work out better (than without an application of voltage to the element). For example, a presence of an electrostatic charge state may have been determined. A voltage can subsequently be applied to the element until the processing and/or examination result has been optimized. For example, this can be implemented when examining the sample (e.g. by way of recording an image using the particle beam particles). In such a case, the electrostatic charge state can be determined e.g. by way of an image distortion according to an exemplary embodiment, with the voltage at the element being adjusted until a better image sets in. Thus, the voltage at the element can be altered depending on the electrostatic charge state status.

However, the aforementioned approach can also be implemented more specifically. For example, the determination of the electrostatic charge state may comprise a determination of a value for the electrostatic charge state of the sample. For example, the voltage applied to the element may depend on the determined value of the electrostatic charge state. For example, an appropriate voltage U1 can be applied to the element given a first electrostatic charge state of C1. In the case of a second electrostatic charge state of C2, an appropriate voltage U2 (which differs from U1) can be applied to the element.

For example, the applied voltage may also depend on a range in which a certain value of the electrostatic charge state of the sample falls. For example, an appropriate voltage U1 can be applied to the element given a value of an electrostatic charge state located in a first range (e.g. between values X1 and X2). For example, an appropriate voltage U2 (which differs from U1) can be applied to the element given a value of the electrostatic charge state located in a second range (e.g. between values X3 and X4).

In an example, a voltage can be applied such that a defined particle beam property of the particle beam is present at the point of incidence on the sample. For example, a countermeasure which minimizes (or compensates) the charging effects of the electrostatic charge state of the sample described herein can be implemented by way of voltage at the element. For example, the countermeasure can ensure that a particle beam property at the point of incidence has the desired value even though an electric field (caused by the electrostatic charge state of the sample) actually influences this particle beam property. For example, a first particle beam property of the particle beam with a value of T1 might have been set (e.g. by way of an appropriate configuration of a particle beam device) during processing and/or an examination. However, on account of the electrostatic charge state, this first particle beam property has a value that differs from T1 at the point of incidence on the sample. In this respect, a countermeasure can be implemented by way of the element. Thus, a voltage can be applied to the element on the basis of the electrostatic charge state present, with the result that the first particle beam property at the point of incidence on the sample nevertheless has the value T1. For example, it is not therefore necessary to adjust the configuration of the particle beam device in the approach described herein in order to implement a successful countermeasure. Rather, it may be sufficient to implement the desired correction of (or countermeasure for) the particle beam in respect of the determination of the electrostatic charge state of the sample by way of the voltage at the element.

For example, the interaction with the released particles can also be adjusted in view of the determined electrostatic charge state by way of the voltage at the element. Thus the countermeasure described herein can also find application for the released particles.

For example, the particle beam-induced reaction for which the particle beam is provided for processing on the sample can also be adapted in view of the determined electrostatic charge state by way of the voltage at the element. Thus the countermeasure described herein can also find application for a particle beam-induced reaction.

For example, known measures do not implement any countermeasure by way of an element in the surroundings of the sample. Instead, the particle beam is simply altered (a priori), for example by way of an appropriate setting of the particle beam device that provides the particle beam. This can allow the desired particle beam property to be present at the point of incidence on the sample even though an electric field (caused by the electrostatic charge state) is present there. Thus, the particle beam is made available incorrectly for the sample such that it nevertheless lands correctly on the sample as a result of the charging effects of the electrostatic charge state. In known approaches, the electrostatic charge state is determined e.g. on the basis of drift markers. Subsequently, the particle beam is guided to the sample with other particle beam properties on the basis of this information, with the result that ultimately the desired particle beam properties are present at the point of incidence on the sample.

By contrast, the method described herein can provide an alternative for handling charging effects of electrostatically charged samples. For example, the method described herein makes it possible to manage without a complex readjustment of a particle beam device that provides the particle beam. According to the method described herein, using voltage applied to the element to address the electrostatic charge state effects of the sample when processing and/or examining may be sufficient. However, the method described herein can also be combined with other methods which take account of the electrostatic charge state of the sample from a technical point of view by altering the particle beam.

For example, the electrostatic charge state may have been caused by the provision of the particle beam on the sample during the processing and/or examination.

Thus, the provision of a particle beam on a sample may bring about a positive, negative or neutral electrostatic charge state of the sample. For example, the basic mechanism can be understood as the creation of two charge flows that are capable of influencing the net charge of the electrostatic charge state of the sample. Firstly, the particle beam provided at the sample optionally introduces a charge into the sample (as first charge flow). Secondly, this may cause a reaction in the sample, within the scope of which charge may be removed from the sample (as second charge flow). Hence, a resultant net charge of the sample may be caused (locally or globally).

Thus, the assumption that can be made when processing and/or examining a sample using a particle beam is that the sample might charge electrostatically. According to the method described herein, it is possible for example to determine the electrostatic charge state at all times during the processing and/or examination, and implement an appropriate countermeasure by way of applying voltage to the element. The method described herein can thus represent e.g. a dynamic consideration of the state of the electrostatic charge state of the sample. Finally, a change in the electrostatic charge state over time when processing and/or examining can be made possible by way of the method described herein. The method described herein can differ from a static adjustment for correcting a particle beam, which for example is applied over the entire processing and/or examining procedure.

In an example, the method comprises processing and/or an examination of the sample using the particle beam before determining the electrostatic charge state of the sample and applying voltage to the element based at least in part on the determined electrostatic charge state. In this case, the electrostatic charge state might have been caused for example by processing and/or examining the sample using the particle beam. Subsequently (following the determination of the electrostatic charge state and the application of voltage), there can be e.g. renewed processing and/or a renewed examination using the particle beam.

In an example, the application of voltage might cause an electric field at a point of incidence of the particle beam on the sample. For example, the element might be arranged in the surroundings of the sample such that a voltage applied to the element causes an electric field at the point of incidence of the particle beam on the sample. By arranging the element and voltage applied thereto, this electric field can be designed such that the particle beam particles and/or exposed particles can be influenced. For example, the electric field might be sufficient to minimize (or compensate) the charging effects of the electrostatic charge state of the sample described herein. The electric field emanating from the element may e.g. enable a defined particle beam property at the point of incidence of the particle beam on the sample, based on the electrostatic charge state of the sample.

In an example, the application of voltage can be implemented such that this influences a landing energy of particle beam particles on the sample. For example, the electric field caused by the electrostatic charge state (and emanating from the sample) might change the landing energy of the particles on the sample. For example, the electrostatic charge state might increase or reduce the landing energy.

The application of voltage can in return cause an additional electric field at the point of incidence of the particles, and this additional electric field can likewise influence the landing energy of the particles there. For example, the electric field caused by the element can purposefully compensate unwanted changes in the landing energy on account of the electrostatic charge state, and thus lead to the desired landing energy.

In an example, the application of voltage can be implemented such that the landing energy is within a first predetermined value range. For example, the landing energy of the particle beam particles can be set by way of the applied voltage to a specific value (which e.g. is located within the predetermined value range) on the basis of the determined electrostatic charge state of the sample. For example, this does not necessarily require an adjustment of the particle beam device that provides the particle beam. For example, the landing energy can be changed merely by applying voltage to the element, with the result that the value of the desired landing energy is present.

In this respect, the following example can be called upon. For example, there might not be any (noteworthy) electrostatic charge state of the sample at the outset. Thus, a desired landing energy can be set by setting particle beam properties (e.g. by way of a particle beam device) when processing and/or examining the sample. However, an electrostatic charge state of the sample might arise over the course of the processing and/or examination. For example, the resultant electric field can reduce or increase the landing energy of the particles. The current landing energy can thus deviate from the landing energy chosen at the outset. A change in the landing energy can be caused by applying voltage to the element on the basis of the determined electrostatic charge state, with the result that the current landing energy corresponds again to the landing energy chosen at the outset. It is also conceivable that the application of voltage to the element allows the setting of a landing energy not previously applied in the method. For example, varying the landing energy might be expedient for a method. Thus, the method described herein can also be used e.g. to change the landing energy over the course of the method, and this may be implemented in view of the present electrostatic charge state of the sample. For example, all this requires is a change in voltage at the element.

In an example, the application of voltage can be implemented such that the electrostatic charge state of the sample is at least partly compensated. For example, an electrostatic charge state of the sample might be present locally (or globally) on account of e.g. a local (or global) accumulation of charge carriers. A corresponding electric field can be caused by this accumulation. The latter can be referred to e.g. as charge state field herein. The application of voltage to the element in this respect can be implemented such that an additional electric field is caused in return. The latter can be referred to as compensation field herein. The voltage at the element can be chosen such that the compensation field is able to at least partly attenuate the charge state field. For example, a field vector of the compensation field can be aligned opposite to a field vector of the charge state field, with the result that the field vector of the charge state field is reduced.

An adjustment of the voltage at the element thus need not be restricted to the influencing of the landing energy of the particles. The voltage applied to the element can also be used to address local (or global) charge state effects of the sample. For example, bothersome charge state effects which influence the particle beam can thus be minimized or compensated.

In an example, the application of voltage can cause the electrostatic charge state to be within a second predetermined value range. For example, a defined electrostatic charge state of the sample can also be induced by applying the voltage to the element. By applying the voltage it is possible e.g. to cause a positive, negative or neutral (local or global) electrostatic charge state of the sample on the basis of the determined electrostatic charge state.

In an example, the landing energy of the particles and the electrostatic charge state of the sample can be influenced using the method described herein. For example, the landing energy of the particles can be set at one instance, and the electrostatic charge state of the sample at another. It should be mentioned that these settings may overlap. For example, the electrostatic charge state of the sample might also change by adjusting the landing energy of the particles. However, the application of voltage in such a case may mainly be directed at the optimization of the landing energy. For example, the landing energy of the particles might also change by adjusting the electrostatic charge state of the sample. However, the application of voltage in such a case may mainly be directed at the optimization of the electrostatic charge state. It is also conceivable in an example that the application sets both the landing energy of the particles and the electrostatic charge state of the sample in a targeted manner. Thus, the landing energy of the particles and the electrostatic charge state of the sample can be optimized. In this respect, reference is also made to the further examples described herein, in which e.g. two more segments are used in the element.

In an example, the steps of the method of the first aspect can be repeated at least once. For example, the determination of the electrostatic charge state and the application of voltage to the element on the basis of the electrostatic charge state can be considered to be a sequence in the method. This sequence can be repeated one or more times over the course of the method. It should be observed that other steps (e.g. processing and/or an examination of the sample) might also occur within a sequence between the aforementioned determination of the electrostatic charge state and the application of voltage. Likewise, other steps might occur within the sequence, before the determination and/or after the application.

In this respect, reference is made to the example set forth below. Initially, the sample can be processed and/or examined using the particle beam. The processing and/or examination can be interrupted, e.g. after a predetermined time period. Subsequently, a first sequence comprising the determination of the electrostatic charge state and the application of voltage can be implemented. In this case, it is possible to apply e.g. a first voltage in view of the electrostatic charge state of the sample determined within the first sequence. Subsequently, the sample can be processed and/or examined again using the particle beam. For example, the processing and/or examination can be continued. The processing and/or examination can be interrupted again, e.g. after a predetermined time period. Subsequently, a second sequence comprising the determination of the electrostatic charge state and the application of voltage can be implemented. In this case, it is possible to apply e.g. a second voltage (which may differ from the first voltage) in view of the electrostatic charge state determined within the second sequence.

In some examples, a sequence comprising the determination of the electrostatic charge state and the application of voltage can be implemented before the processing and/or the examination of the sample is started.

In an example, the element can be arranged on an underside of the sample located opposite a top side of the sample from which the particle beam is directed at the sample during the processing and/or examination. Thus, within the scope of the method, the particle beam would be incident on the sample from the top side. For example, an aperture of the particle beam and/or the particle source of the particle beam can be arranged on the top side of the sample. The top side can e.g. also comprise the face of the sample which is processed and/or examined using the particle beam. Herein, this face can also be referred to as top face of the sample.

In this example, by contrast, the element can be arranged on the underside of the sample. Thus, for example, the underside of the sample may comprise a side from which the particle beam is not incident on the sample during the processing and/or examination. For example, mechanisms for positioning the sample may be present on the underside. The underside can e.g. also comprise the face of the sample which is not processed and/or examined using the particle beam. Herein, this face can also be referred to as lower face of the sample.

An advantage connected with this arrangement of the element is that the element is not in the way of the incident particle beam. Interference with the particle beam or a complex design of the element allowing unimpeded passage of the particle beam can thus be avoided. Nevertheless, the element can be arranged in surroundings of the sample by way of the positioning on the underside such that the electric field emanating from the element can reliably act on the point of incidence of the particle beam (as described herein). For example, the electric field emanating from the element can act on the point of incidence of the particle beam from the underside and through the sample.

In an example, a gap can be present between the element arranged on the underside of the sample and the sample itself.

In an example, at least a partial area of the sample can be in contact with the element when voltage is applied. For example, the element can be arranged on the underside of the sample, wherein at least a partial area of the sample is in contact with the element. Thus, the sample can be connected to the element arranged on the underside. For example, at least a partial area of the lower face of the sample can be in contact with the element.

Thus, by way of this arrangement, the element can be brought into the surroundings of the sample with less complexity and can be held there stationarily with respect to the sample, e.g. with less outlay.

In an example, the element can comprise a mount for holding the sample and/or be part of a mount for holding the sample. For example, the mount can be configured to position the sample within a particle beam device. For example, the mount may comprise a sample stage and/or a chuck.

In an example, the element can also comprise a part of a mount for holding the sample. For example, the element can be integrated within a mount.

In general, the element may comprise at least one electrode to which the voltage is applied on the basis of the determined electrostatic charge state.

In an example, the mount and/or the element can comprise a base area which is in contact with the sample during the method. For example, the sample can rest on the base area. For example, the lower face of the sample can be in contact with the base area of the mount and/or element. In this context, the lower face of the sample can be smaller than the base area of the mount.

In an example, the application of voltage to the element can cause an electric field to emanate from the base area. For example, the base area can be configured as an electrode (electrically conductively) such that an electric field emanates from the base area when voltage is applied. It is also conceivable that the element (e.g. an electrode) is installed in the mount below an (e.g. electrically non-conductive) base area, wherein an electric field might likewise emanate from the base area when voltage is applied to the element. Thus, in these examples, an electric field can be introduced to the lower face of the sample via the base area (of the mount). For example, this electric field can be substantially the same at each location on the lower face. Thus, application of voltage might lead to the sample being exposed globally to an electric field which emanates from the element.

As described herein, this global electric field based on the determined electrostatic charge state can influence the particle beam when processing and/or examining the sample. For example, a landing energy of the particles on the sample can be set by way of this global electric field. For example, an electrostatic charge state of the sample can be adjusted by way of this global electric field. It is also conceivable that both a landing energy and the electrostatic charge state of the sample can be set by way of this field.

In an example, the element can comprise two or more segments. In such an example, the application of a voltage might comprise: applying a first voltage to a first segment of the element; applying a second voltage to a second segment of the element. For example, the first and the second voltage can be applied simultaneously. In an example, the first and the second voltage can be set independently of one another. Thus, segment-specific voltages can be set. For example, the first voltage might differ from the second voltage. However, it is also conceivable that the first voltage and the second voltage can be the same in special cases. It should be mentioned that the first and second voltage (as described herein) can be set based at least in part on the predetermined electrostatic charge state of the sample, in order to influence the processing and/or examination of the sample appropriately.

In an example, the element can comprise three or more segments, wherein a segment-specific voltage can be applied to each segment. In an example, the element can comprise ten or more segments, wherein a segment-specific voltage can be applied to each segment. In an example, the element can comprise one hundred or more segments, wherein a segment-specific voltage can be applied to each segment. In an example, the element can comprise one thousand or more segments, wherein a segment-specific voltage can be applied to each segment.

As described herein, a segment-specific voltage can be set at least in part on the predetermined electrostatic charge state of the sample, in order to influence the processing and/or examination of the sample appropriately.

In an example, the application of the first and second voltage can be implemented for the purpose of influencing the processing and/or examination of the sample in a first region of the sample. For example, the first and the second segment can be arranged spatially at different locations in the element. However, the first voltage at the first segment and the second voltage at the second element can be used to influence the processing and/or examination of the sample in one region of the sample, specifically the first region.

Thus, the electrostatic charge state of the sample might be distributed e.g. inhomogeneously over the sample. Therefore, implementing a global influence by the element might not be sufficient in all cases. However, using the approach of segmenting the element, it is also possible to take account of one or more local effects of the electrostatic charge state (and minimize and/or compensate these accordingly).

By applying the first voltage to the first segment and the second voltage to the second segment, it is possible e.g. to address two local charge state effects which act on the first region. By applying the first voltage to the first segment, it is e.g. possible to address a first effect of the electrostatic charge state of the sample. By applying the second voltage to the second segment, it is e.g. possible to address a second effect of the electrostatic charge state of the sample. The first and second voltage can be chosen on the basis of the determined electrostatic charge state such that a countermeasure with regards to the first and second effect is present. For example, this can ensure a defined particle beam property in the first region against the background of the electrostatic charge state of the sample (as described herein).

In an example, the application of the first voltage can cause the landing energy of particle beam particles in the first region to be influenced. For example, the first voltage at the first segment can cause a purposeful setting of the landing energy of particle beam particles in the first region. The explanations regarding the influencing of the landing energy in the more general example can also be applied accordingly to the influencing of the landing energy in the first region. For example, the electrostatic charge state may be determined for the first region. On the basis thereof, a first voltage can be chosen such that the landing energy in the first region is within a predetermined value range (or has a predetermined value). Thus, the first effect addressed by the first segment can comprise e.g. a change in the landing energy in the first region on account of the electrostatic charge state of the sample (as described herein).

In addition, or alternatively, the element may be movable relative to the sample. For example, the element may be movable relative to a sample stage and/or a chuck. Specifically, the element may be horizontally movable relative to the sample and/or the sample state and/or the chuck, e.g., the element may be movable in a horizontal plane and/or parallel to the sample and/or the sample stage and/or the chuck. The element may be continuously movable. For example, the element may be continuously movable in a first direction. In addition, the element may be continuously movable in a second direction. Specifically, the first and the second direction may be essentially orthogonal directions. For example, the first and the second direction may span the horizontal plane. In addition, or alternatively, the element may be stepwise movable, e.g., incrementally movable. For example, the element may be movable in a first direction by first increments and movable in a second direction by second increments. Specifically, the first and the second direction may be essentially orthogonal directions. For example, the first and the second direction may span the horizontal plane.

Being movable relative to the sample and/or the sample stage and/or the chuck may comprise that the element is at least partially separated from the sample and/or the sample stage and/or the chuck. Specifically, the element may be vertically separated from the sample and/or the sample stage and/or the chuck. Being vertically separated may comprise that a separation with respect to a direction essentially orthogonal to the horizontal plane is provided. For example, the vertical separation may comprise that the element and the sample and/or the sample stage and/or the chuck are separated by a distance. Generally, the distance may be such as to enable the element to move relative to the sample and/or the sample stage and/or the chuck. In some embodiments, the distance between the element and the sample and/or the sample stage and/or the chuck may be adjustable. For example, the element may be vertically movable. In addition, or alternatively, the sample and/or the sample stage and/or the chuck may be vertically movable.

Generally, the element may be movable relative to the sample and/or the sample stage and/or the chuck such as to essentially follow the particle beam. For example, the element may be movable such as to essentially follow the particle beam, when the particle beam processes and/or examines the sample. Specifically, the element may be movable such as to be located in a vicinity of an impact point of the particle beam on the sample. For example, the element may be movable such as to essentially follow the impact point of the particle beam on the sample, e.g., when the particle beam is directed to and/or moved over the sample. In some examples, the landing energy of the particles of the particle beam may thus be adjusted (e.g. by applying a suitable voltage to element, e.g. as described herein).

In some embodiments, the element may comprise at least two segments. Generally, at least one of the at least two segments may be movable relative to the sample and/or the sample stage and/or the chuck. For example, a first segment may be fixed with respect to the sample and/or the sample stage and/or the chuck. In addition, or alternatively, a second segment may be movable relative to the sample and/or the sample stage and/or the chuck. In addition, or alternatively, the first and the second segment may be movable relative to the sample and/or the sample stage and/or the chuck. For example, the first segment may be movable independently of the second segment. Generally, the first segment may be arranged such as to be vertically separated from the sample and/or the sample stage and/or the chuck by a first distance. In addition, or alternatively the second segment may be arranged such as to be vertically separated from the sample and/or the sample stage and/or the chuck by a second distance. For example, the first and the second distance may essentially coincide. In some embodiments, the first distance and the second distance may differ.

In an example, the determination of the electrostatic charge state can comprise: determining an electrostatic charge state in a second region differing from the first region, the application of the second voltage being based at least in part on the electrostatic charge state determined in the second region.

For example, the electrostatic charge state thus may be determined initially for the second region. This information allows a second voltage to be chosen which, when applied to the second segment, causes the particle beam to be influenced in the first region.

In an example, the application of the second voltage can cause the suppression of an electric field emanating from the second region. For example, a local charge state field might emanate from the second region and might impair the particle beam in the first region. This interfering charge state field can be minimized or compensated using the second voltage, on the basis of the electrostatic charge state in the second region. Thus, the second effect addressed by the second segment can comprise e.g. a change in a particle beam property in the first region on account of the electrostatic charge state of the sample in the second region.

In an example, the application of the second voltage to the second segment can cause an electrostatic charge state in the second region to be within a predetermined value range. Thus, a value of the electrostatic charge state for the second region can be purposefully set with the aid of the second segment, on the basis of the determined electrostatic charge state in the second region.

Thus, by setting the second voltage on the second segment, it is possible to address a local charge state effect of the sample in the second region, with the result that the processing and/or examination in the first region can be optimized.

The mechanisms for the first segment and the second segment described herein can also be applied to elements with three or more segments. For example, a first set of two or more segments can be used to set the landing energy in the first region. In this case, respective different segment-specific voltages may also be applied to the segments of the first set in order to set the landing energy in the first region.

Further, e.g. a second set of two or more segments can be used to suppress charge state fields which may act on the first region. In this case, respective different segment-specific voltages may also be applied to the segments of the second set in order to minimize the effect of the charge state fields on the particle beam present in the first region. For example, a plurality of locally distributed charge state fields may be present on the sample, the interfering effects of which can be minimized by way of the segment-specific voltages at the segments of the second set. To this end, it is possible to e.g. also determine the electrostatic charge state at the various regions of the sample from which the corresponding second set of segments, which is able to address the charge state fields present, is formed. Subsequently, it is possible to determine the segment-specific voltages in order to minimize the interfering effects of these charge state fields.

In an example, the element can be configured so that the two or more segments divide the top face of the sample into two or more corresponding surface regions. In this case, a surface region can be (substantially) exposed to an electric field which emanates from a segment assigned to this surface region. For example, the first segment (described herein) can thus bound the top face of the sample within a first surface region. Thus, an electric field emanating from the first segment would substantially act on this first surface region. The second segment (described herein) can bound the top face of the sample within a second surface region. Thus, an electric field emanating from the second segment would substantially act on this second surface region. Accordingly, these circumstances can apply to a third segment and a third surface region, a fourth segment and a fourth surface region, etc.

By way of example, the two or more segments can also be considered to be pixels of the element which divide the top face of the sample into corresponding surface pixels (the surface regions). Thus, e.g. an electrostatic charge state can be determined for one or more surface pixels. This information can be used to determine a voltage for the pixels of the element in order to optimize, in a surface pixel (or a plurality of contiguous surface pixels), the processing and/or examination of the sample using the particle beam.

Accordingly, different voltages can be applied for different pixels of the element. This may result in different electric fields that act on the surface pixels of the sample. Thus, each surface pixel can be assigned a corresponding electric field (with e.g. a maximum field strength). Using this approach of the segmented element, it is thus possible to technically reliably address both local and global variations in the electrostatic charge state of the sample with a high degree of freedom.

In an example, the method can be performed for the purpose of processing and/or examining a lithography object. The sample might thus comprise a lithography object, for example.

The lithography object may comprise e.g. a mask for a lithographic method. For example, the lithography object may comprise an optical lithography object (e.g. the object might be designed to be exposed to an exposure radiation during the optical lithography). For example, the object may comprise an EUV mask for EUV lithography. However, it is also conceivable that the object comprises a mask for any other optical lithographic method, e.g. for DUV lithography, UV lithography and/or x-ray lithography. For example, the object may comprise a transmissive and/or reflective mask for (optical) lithography. Thus, e.g. the mask may be designed such that the exposure radiation is transmitted by the mask or reflected by the mask during (optical) lithography. It is also conceivable that the lithography object need not necessarily comprise an optical lithography object. For example, the lithography object might also be designed for nonoptical lithography, e.g. might also comprise a stamp for nanoimprint lithography.

In an example, the lithography object may also comprise a mask blank. In the lithographic industry, mask blanks are a known starting material for a mask. For example, the mask blank may not comprise any imaging structures like the mask itself but may comprise the layer material thereof.

In an example, the method can however also be performed for the purpose of processing and/or examining any desired sample. For example, the sample might also comprise a microchip, a wafer and/or a biological sample.

In an example, the particle beam may comprise at least one of the following: an electron beam, an ion beam, a photon beam. For example, an electron beam can be used as particle beam when processing and/or examining the sample. For example, an ion beam can be used as particle beam when processing and/or examining the sample. For example, a photon beam can be used as particle beam when processing and/or examining the sample.

A second aspect relates to a computer program for executing a method of the first aspect.

A third aspect relates to a device for processing and/or examining a sample with a particle beam, comprising: determination means for determining an electrostatic charge state of the sample; an element arranged in surroundings of the sample when the sample is arranged in a sample position in the device; application means for applying a voltage to the element, based at least in part on the determined electrostatic charge state.

In an example, the device may further comprise: a memory comprising instructions for executing a method of the first aspect; a computer system which is capable of controlling the determination means and the application means, wherein, when the computer system executes the instructions from the memory, the device is caused to carry out a method of the first aspect. For example, the computer system may comprise a computer, a computing unit, a microprocessor, etc. For example, the computer system may be communicatively coupled to the components of the device such that a signal output by the computer system can cause a change in a component of the device.

For example, the device can be configured to let the method of the first aspect run in automated or semiautomated fashion. For example, the determination means may comprise one or more components of the device which automatically (or semi-automatically) enable a determination of the electrostatic charge state over the course of the method. For example, the determination means can be used to determine the electrostatic charge state in the surface regions of the sample (also referred to as surface pixels). For example, the determination means may comprise a configuration of the computer system of the device which triggers a determination of the electrostatic charge state over the course of the method (e.g. after a defined period of time following the method start). For example, this trigger can also be caused manually by an operator (e.g. by way of a corresponding user interface on the device). For example, the determination means may also comprise a control unit which deflects and/or adjusts the particle beam of the device, for example in order to record positions of reference structures on the sample for the purpose of determining the electrostatic charge state. The computer system of the device can e.g. carry out the computing operations on the basis of the recorded positions of the reference structures for the purpose of determining the electrostatic charge state.

The application means for applying a voltage to the element based at least in part on the determined electrostatic charge state may comprise one or more components of the device which are able to fulfil this functionality. Thus, the application means for applying the voltage may for example comprise a control unit in which the intended voltage to be applied is stored. Thus, the means can automatically apply an appropriate voltage on the basis of the determined electrostatic charge state. For example, the control unit can be communicatively coupled to the determination means such that the determined voltage can be stored in the control unit. For example, the control unit may comprise a closed-loop and/or open-loop control mechanism able to control the application of the electrical voltage to the element. For example, the application means may also comprise a voltage source and/or a power circuit which can enable the generation of the voltage. For example, the control unit might be comprised in the computer system of the device.

The element may (as described herein) comprise an electrode which might be coupled to the application means. The application means can apply the generated voltage to the element, e.g. by way of the control unit of the means. For example, the device can be configured to position the element in surroundings of the sample when the sample is in the sample position in the device. The sample position can e.g. correspond to a position of the sample in which the sample is processed and/or examined using the particle beam. For example, the element can also be arranged statically in the device such that the element need not always be positioned (and, without a comprehensive readjustment, the element is situated in the surroundings of the sample when the latter is arranged in the sample position). For example, the element can be configured such that it is e.g. also arranged in the sample position. For example, if the sample position is modified then the positioning of the element can also change accordingly, and so said element can be in the surroundings of the sample without a comprehensive readjustment.

In an example, arrangement of the sample in the sample position can lead to the element being arranged on an underside of the sample located opposite a top side of the sample from which the particle beam is directed at the sample during the processing and/or examination.

For example, the element might not be arranged on the side of the sample on which the particle beam source and/or an aperture of the particle beam are situated. In this configuration, the element cannot be in the way of the particle beam when the latter is incident on the sample. A complex construction of the element which e.g. comprises a passage for the particle beam can thus be avoided. For example, it is also possible to avoid complicated adjustments of the sample, of the element and/or corresponding positioning of the particle beam such that the latter is guided to the passage.

In an example, the device can be configured such that at least a partial area of the underside of the sample is in contact with the element when voltage is applied.

In an example, the element can comprise a mount for holding the sample. For example, the mount may comprise a sample stage and/or a chuck.

In an example, the mount can comprise a base area which is in contact with the underside of the sample when the sample is arranged in the sample position.

In an example, the element can comprise two or more segments, wherein a first voltage can be applied to a first segment and a second voltage can be applied to a second segment of the element by means of the application means.

It should be mentioned that the features (and also examples) of the method (or of the computer program) that are specified herein may also be applied or applicable correspondingly to the device mentioned. For example, the features of the element (e.g. the mount) described in relation to the method might also apply to the element (e.g. the mount) comprised in the device of the third aspect. It should also be mentioned that the features (and also examples) of the device that are specified herein may likewise be applied or applicable correspondingly to the method (and computer program) described herein.

A fourth aspect relates to a mount for holding a sample in a device for processing and/or examining the sample using a particle beam, the mount comprising: two or more segments; wherein the two or more segments are designed to be coupled to an application means for applying an electrical voltage to the mount, wherein the two or more segments are designed for permanent contact with the sample during the processing and/or examination.

In an example, the mount can for example comprise three or more segments. In an example, the mount can for example comprise 10 or more segments. In an example, the mount can for example comprise 100 or more segments. In an example, the mount can for example comprise 1000 or more segments. In an example, the mount can be designed to hold a mask for (e.g. optical) lithography.

It should be mentioned that the features (and also examples) of the element (e.g. the mount) that are specified herein, which are described in relation to the method and/or the device, may likewise be applied or applicable correspondingly to the aforementioned mount of the fourth aspect.

### 4. Brief description of the drawings

The following drawings are described in the detailed description below:
- Fig. 1 A-C: schematically shows the irradiation of an electrostatically uncharged lithographic mask with an electron beam, wherein the mask has a reference structure and a defect with four drift markers.
- Fig. 2 A-C: schematically shows the irradiation of the mask from Figures 1 A-C, wherein the mask has a positive electrostatic charge state.
- Fig. 3 A-C: schematically shows the irradiation of the mask from Figures 1 A-C, wherein the mask has a negative electrostatic charge state.
- Fig. 4: schematically shows an example of the aspects described herein, in which a sample is processed and/or examined using a particle beam, wherein a voltage is applied to an element in surroundings of the sample on the basis of an electrostatic charge state of the sample.
- Fig. 5: shows steps according to a method described herein, by way of example in a flowchart.
- Fig. 6: schematically shows a further example of the aspects described herein, in which a sample is processed and/or examined using a particle beam, wherein the application of voltage to the element comprises an application of segment-specific voltages to different segments of the element.
- Fig. 7: schematically shows a plan view of an example of a mount for holding a sample in a device according to the disclosure described herein.

### 5. Detailed description

Examples of the method described herein and of the device described herein for processing and/or examining a sample are explained in detail below using the example of lithographic masks and a modified scanning electron microscope. However, the method need not be limited to the reflective and transmissive photomasks described below. Instead, the method described herein can be used for any desired samples (e.g., for imprinting stamps for nanoimprint lithography, wafers, ICs, MEMS, NEMS and PICs, biological samples). Further, the device described herein is not limited to the example described below. Instead of the modified scanning electron microscope discussed, it is also possible to employ any scanning particle microscope which uses for example a focused ion beam and/or a focused photon beam as energy source.

Currently preferred embodiments of the present invention are explained in more detail below with reference to the drawings.

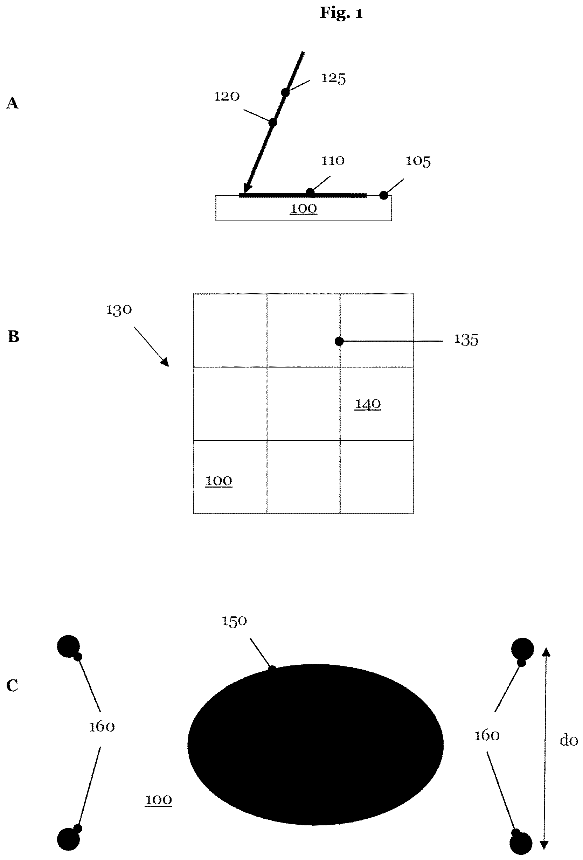

Figures 1 A-C show an exemplary lithographic mask 100 (hereinafter mask 100 for short) having a reference structure 130, a defect 150 and four reference elements 160, according to one example.

Fig. 1A shows a section through the mask 100, the surface 105 of which carries a pattern 110. The surface 105 of the mask 100 is irradiated by an electron beam 120.

For example, the electron beam can be provided at a specific position on the surface 105 for the purpose of processing the mask 100. For example, an electron beam-induced reaction may be caused on the mask 100 by the electron beam and a gas provided. The electron beam-induced reaction may comprise e.g. an electron beam-induced deposition and/or electron beam-induced etching. For example, the electron beam-induced reaction may be carried out within the scope of a mask repair (e.g. in order to deposit or etch away missing or excess material, for example of a pattern element on the mask).

For example, the electron beam can also be provided at a specific position on the surface 105 for the purpose of examining the mask 100. For example, for an image representation of the mask 100, the electron beam can be raster-scanned over the surface. Electrons released thereby can be detected for image recording purposes. Thus, the electron beam can be used for imaging purposes, as known for a scanning electron microscope.

Fig. 1B presents a schematic plan view of a reference structure 130 of the mask 100. The exemplary reference structure 130 of Fig. 1B is a square that is divided into nine sub-squares 140 by lines 135. The reference structure 130 may be arranged in a manner distributed over the mask 100 at regular or irregular intervals. The reference structure 130 may be used to determine an electrostatic charge state of the mask 100 (or of a sample 100 in general terms). As a rule, both the positions of the reference structures 130 and the size thereof are known from the manufacturer of the mask 100. If this is not the case, the positions and the size of the reference structures 130 may be determined using for example a mask inspection tool.

Fig. 1C reproduces a schematic view of a defect 150 in the mask 100. The exemplary defect 150 is an excess-material defect or a dark defect 150. The method described herein may also be used for the precise processing and/or examination of a missing-material defect or a clear defect 150. The processing and/or examination of the defect may be implemented within the scope of an (e.g. multistage) repair process for the mask 100. Four reference elements 160 in the form of drift markers 160 are deposited around the defect 150 in Fig. 1C. The drift markers 160 may be deposited on the mask 100 around the defect 150 with the aid of an electron beam-induced deposition process while providing at least one precursor gas in the form of a deposition gas. In this respect, reference is also made to the publication WO2019238668A1, which relates to aspects of drift correction and inter alia also mentions the creation of drift markers and an exemplary drift correction. The drift markers 160 span a two-dimensional (2-D) coordinate system in the example of Fig. 1C. Three reference elements 160 that are not arranged on a straight line are sufficient for spanning a 2-D coordinate system. The drift markers 160 are predominantly scanned periodically with the electron beam 120 during a repair process of the defect 150 in order to detect a drift of the defect 150 or of the drift markers 160 with respect to the reference positions of the drift markers 160. The change in the positions of the drift markers 160 with respect to their reference positions may also be used, in addition to determining a relative drift between the electron beam 120 and the drift markers 160 of the mask 100 or the defect 150, to ascertain an electrostatic charge of the mask 100.

For the raster-scanning of the electron beam 120 over the defect 150 in the mask 100 during repair thereof, it may be advantageous to keep the landing energy of the electrons 125 on the defect 150 low in order to make the diameter of the local chemical reaction induced by the electron beam 120 as small as possible. The provision of the particle beam for processing purposes described herein can be implemented e.g. with electron landing energies of 3 keV, 1 keV, 600 eV, preferably 400 eV and most preferably 300 eV or less. To image the drift markers 160, it may e.g. be advantageous to use electron landing energies that are also used to repair a defect. The provision of the particle beam for examination purposes described herein can be implemented e.g. with electron landing energies of the order of 3 keV, 1 keV, 600 eV, preferably 400 eV and most preferably 300 eV or less. However, it may also be advantageous to implement the imaging of drift markers at different electron landing energies. The provision of the particle beam for examination purposes described herein can e.g. be implemented with electron landing energies of the order of greater than 600 eV, for instance 3 keV.

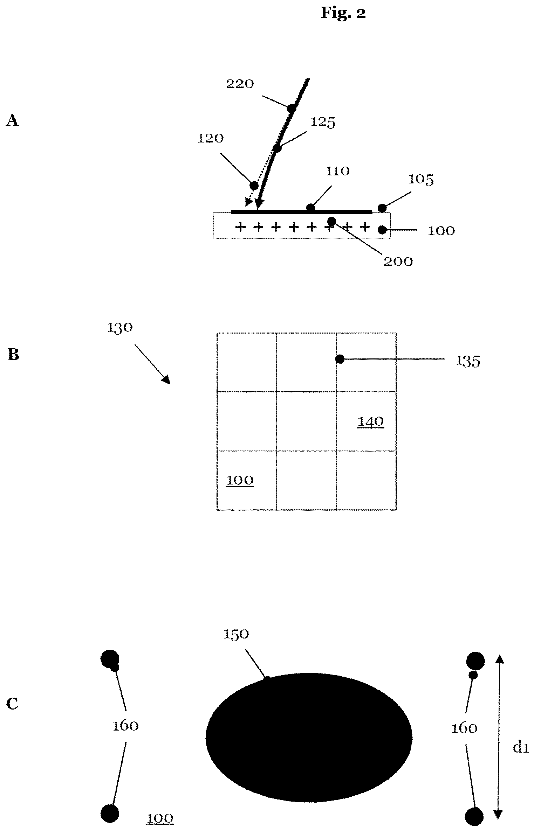

Figures 2 A-C once again repeat the illustrations of Figures 1A-C. In contrast to Figures 1A-C, the mask 100 in Figures 2 A-C however has a positive electrostatic charge state 200. The electric field of the positive electrostatic charge state 200 bends the electron beam 220 towards the surface 105 of the mask 100. For comparison, Fig. 2 A additionally uses dashes to illustrate the electron beam 120 that would be incident on the surface 105 of the mask 100 if it were not positively electrostatically charged. Fig. 2 B presents the reference structure 130 as is imaged by the electron beam 220 due to the positive electrostatic sample charge state 200 of the mask 100. In comparison to the reference structure 130 in Fig. 1 B, the reference structure 130 of the positively electrostatically charged mask 100 appears smaller. Fig. 2 C shows the image representation of the defect 150 and of the four drift markers 160, which the electron beam 220 acquires due to the positive electrostatic mask charge 200 of these structural elements. The distance between the drift markers 160 in Fig. 2 C appears to be reduced compared to that in Fig. 1C. Thus, the marked distance d1 between two reference markers in Fig. 2 C is less than the distance do present between the same reference markers in Fig. 1C.

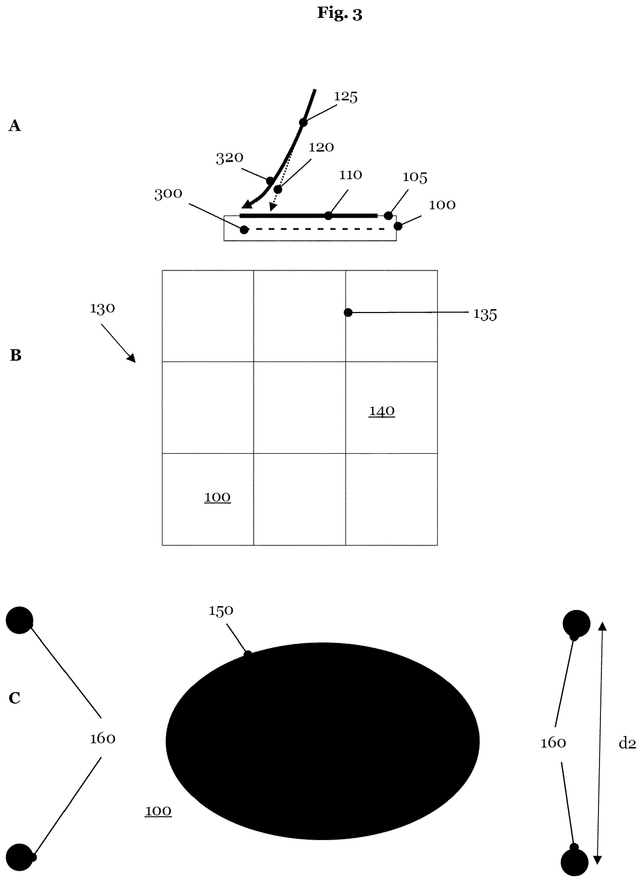

Figures 3 A-C show Figures 2 A-C, wherein the mask 100 now however has a negative electrostatic charge state 300 instead of a positive electrostatic charge state 200. The electric field of the negative sample charge state 300 bends the path of the electrons 125 of the electron beam 320 away from the surface 105 of the mask 100. For comparison, the trajectory of the electron beam 120 incident on a non-electrostatically charged mask 100 is once again illustrated in dashed form. As illustrated in Fig. 3 B, the deflection of the electron beam 320 caused by the negative electrostatic charge 300 increases the image representation of the reference structure 130 compared to the image thereof in Fig. 1B. The same applies to the image representation of the defect 150 and of the four drift markers 160 in Fig. 3 C, again with reference to Fig. 1C. Thus, the marked distance d2 between two reference markers in Fig. 3 C is greater than the distance do present between the same reference markers in Fig. 1C.

It is possible to ascertain both the magnitude, i.e. numerical value, and the sign of the electrostatic charge state 200, 300 of the mask 100 from the change in size of the reference structure 130, caused by an electrostatic charge state 200, 300 of the mask 100 or, generally, of a sample 100. As illustrated by Figures 3 A, 3 B and 3 C, an electrostatic sample charge 200, 300 may also be ascertained from measured displacements of the drift markers 160 with respect to the reference positions thereof. This in turn applies to the absolute value and the sign of an electrostatic sample charge state 200, 300.

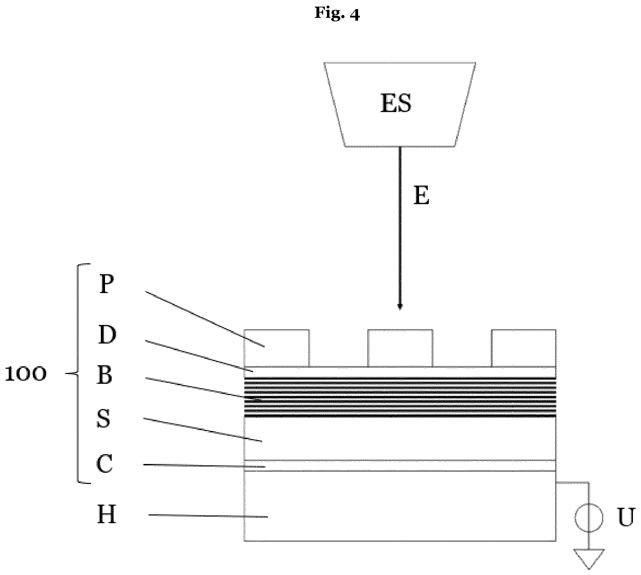

Fig. 4 schematically shows an example of the aspects described herein, in which a sample is processed and/or examined using a particle beam, wherein a voltage is applied to an element in surroundings of the sample on the basis of an electrostatic charge state of the sample.

In this example, the mask 100 comprises a mask for EUV lithography (an EUV mask). The EUV mask 100 may comprise a substrate S. A multilayer stack B may be applied to the substrate S. For example, the multilayer stack B may comprise a Bragg mirror. For example, the Bragg mirror may have a reflective effect with regard to the EUV radiation used during EUV lithography. A capping layer D may be applied to the multilayer stack B. For example, the capping layer D may serve to protect the multilayer stack B. For example, one or more pattern elements P of the mask 100 may be applied to the capping layer C. For example, the pattern elements P might be absorber structures which absorb the EUV radiation during EUV lithography. For example, the pattern elements P might also have a radiation-absorbent and/or phase-shifting design in relation to the EUV radiation during UV lithography. For example, the EUV mask may be electrically insulating. For example, one layer of the EUV mask may have electrically insulating properties. In such a case, a charge generated on the capping layer D or in a pattern element P could not be discharged through the mask via the substrate to e.g. a mask mount. For example, the substrate S can be electrically insulating. A coating layer C may adjoin the substrate S. For example, the coating layer C can be electrically conductive. For example, the coating layer C can define the lower face of the EUV mask 100. For example, the capping layer D with the pattern elements P can define the top face of the EUV mask 100. A current cannot always flow from the top face to the lower face on account of the electrical insulation of the EUV mask 100 (e.g. on account of the substrate S). Thus, EUV masks, once electrostatically charged, cannot easily be electrostatically adjusted in all cases. For instance, a desired electrostatic charge state of the EUV mask cannot always be set easily from a technical point of view.

For example, the electrostatic charge state in the pattern elements P, the capping layer D and/or the multilayer stack B, which might have been caused by e.g. the electron beam E directed at the EUV mask 100 during processing and/or the examination, might be problematic. For example, EUV masks 100 (or samples in general) can be processed and/or examined using a particle beam in an active region of the EUV mask 100, with the particle beam being directed at the active region. For example, charge can be introduced into the material of the EUV mask 100 (as described herein) by the particle beam (e.g. an electron beam).

As mentioned, a pattern element P can be defective since mask errors (e.g. in the case of EUV masks) cannot always be prevented. For example, the design of the mask 100 might indicate that a material of the pattern element P should be present at a given location, but this material might be missing. For example, the design of the mask 100 might indicate that no material should be present at given locations, but a pattern element P might have excess material there. These defects can also cause corresponding defects during lithography (e.g. during EUV lithography). Thus, processing and/or examining the EUV mask may comprise e.g. a repair, within the scope of which defective pattern elements P are repaired (e.g. by the deposition and/or etching of material). In this context, additional reference is made to the publication EP2702603A2, which relates to corresponding aspects of pattern element repair. However an (unwanted) electrostatic charge state of the mask, for example, might be caused by the particle beam-based repair.

For example, as a result of the electrostatic charge state, the EUV mask 100 might act like a capacitor. The pattern element P of the mask might comprise a metal, for example. The capping layer D can further also comprise a metal. The multilayer stack B can also comprise a metal, e.g. one or more molybdenum layers. Introduced charges can be stored e.g. in delocalized fashion in these metallic regions (e.g. in contrast to local accumulation in non-conductive materials). Thus, e.g. the upper (metallic) electrically conductive layers of the EUV mask 100 might act like a capacitor plate which globally has a certain charge.

However, it should be observed that a local electrostatic charge state might also be present in the metallic regions of the EUV mask 100. For example, the local accumulation of charge might be caused by charge trapping at interfaces of the EUV mask 100. For example, charge might be trapped locally at these interfaces, causing a local electric field. For example, the interfaces might comprise mutually adjacent layers, structure edges and/or surfaces.

For example, local accumulations might also be caused by insulated structures on the EUV mask. Such insulated layers can likewise be created by a partial deposition of non-conductive material within the scope of the examination and/or processing of the EUV mask 100 (e.g. during the repair). As mentioned, EUV masks 100 can be processed and/or examined in an active region of the EUV mask 100 using a particle beam. If an electrically nonconductive material is present in this active region, the assumption can be made that e.g. excess charge is introduced predominantly locally by way of the particle beam.

In summary, an EUV mask might thus become electrostatically charged globally and/or locally during the processing and/or examination using a particle beam.

The method described herein may enable reliable circumvention of the effects of this electrostatic charge state when processing and/or examining EUV masks.

Fig. 4 depicts an exemplary repair process for a pattern element P of the EUV mask 100. The repair process comprises processing and/or examining the EUV mask 100 using the electron beam E. The latter is made available by the electron beam source ES. For example, the repair process can be performed in an electron beam device which further also comprises one or more components for control and/or focusing the electron beam.

Further, the electron beam device may comprise a mount H, which is coupled to a voltage source U. In this case, the mount may comprise the element described herein, which is arranged in surroundings of a sample (the EUV mask 100 in this case). For example, the mount H might also comprise a sample stage, to which the EUV mask 100 has been fastened. For example, the sample stage might also be referred to as "stage" (or "chuck"). A voltage can be applied to the mount by way of the voltage source U. To this end, e.g. an electrode can be installed in the mount H, with the electrode being coupled to the voltage source U. For instance, the mount H might also be electrically conductive and thus act as an electrode. An electric field can emanate from the base area of the mount H as a result of applying voltage to the mount H by way of the voltage source U. In the example of Fig. 4, the base area of the mount H is in contact with the coating layer C of the EUV mask 100. The electric field emanating from the mount H can thus act globally on the EUV masks 100. The voltage of the voltage source U can be chosen such that the electric field of the mount H at the point of incidence of the electron beam E on the EUV mask 100 is large enough to interact with the electrons in the electron beam E.

The EUV mask 100 can become electrostatically charged over the course of the repair process using the electron beam E. The electric fields emanating from the EUV mask 100 as a result can undesirably adversely affect the electron beam E. For example, this may cause a change in the landing energy of the electron beam E over the course of the repair process. This can be addressed by the approach described herein.

During the method, a time-varying counter field can be created on the mount H in order to compensate for an electrostatic charge state of the mask which has arisen due to bombardment with the electrons of the electron beam E during the repair of the EUV mask 100. For example, the landing energy of the electrons on the EUV mask 100 can be modulated by way of the mount H. During the processing and/or examination of the EUV mask 100, the method described herein can allow, by way of the mount H, a dynamic correction of the landing energy of the electrons by the absolute value caused by electric fields of the EUV mask 100.

To this end, the electrostatic charge state of the EUV mask 100 is determined first, e.g. on the basis of the analysis of structures on the EUV mask (as described herein). This information can be used to determine the voltage that needs to be applied to the mount H so that the landing energy of the electrons has the desired value again.

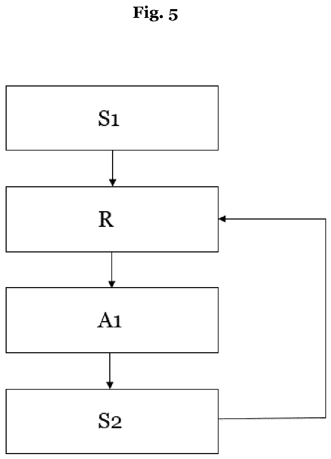

Fig. 5 presents steps according to the method described herein, by way of example in a flowchart. Initially, in a first setting step S1, the desired landing energy of the electrons can be set by way of a first voltage applied to the mount H by the voltage source U. If there were no electrostatic charging of the EUV mask 100, this first voltage could be maintained statically over the course of the method in this ideal case since the landing energy would remain constant. However, this is usually not the case in reality on account of the induced electrostatic charge state of the EUV mask 100.

In a next step, e.g. a repair step R, the EUV mask 100 can be repaired using the electron beam E. For example, this may comprise an electron beam-induced deposition and/or etching. In this case, the electron beam can also be guided over the EUV mask for imaging purposes. The repair can cause electrostatic charging of the sample. According to the method described herein, the electrostatic charge state of the EUV mask 100 is determined during the repair in an analysis step A1. For example, this is implemented by analysing scanning electron recordings of drift markers situated on the EUV mask 100.

In a next setting step S2, a voltage based on the determined electrostatic charge state (determined in analysis step A1) is applied to the mount H. This step can also be referred to as compensation step. In this case, the voltage is chosen such that the mount H creates an electric counter field which acts on the EUV mask 100. The electric counter field is able to compensate the electric field emanating from the EUV mask 100 as a result of the charges introduced during the repair. As a result of the compensation, the landing energy of the electrons in the electron beam once again corresponds to the target value (set in the first step). Subsequently, a repair step R can be carried out again, wherein the repair is implemented with the desired landing energy as a result of the voltage applied during the setting step S2.

The compensation by the mount can be implemented dynamically during the repair. For example, the steps can be repeated iteratively, as depicted in Fig. 5**.** Thus, the electrostatic charge state can be determined multiple times during the repair (analysis step A1) and the compensation step (setting step S2) can be carried out accordingly, with a subsequent repair step R. Thus, the electron landing energy can be corrected multiple times within the scope of the method.

It should be mentioned that the landing energy can be determined e.g. on the basis of the settings of the electron beam device in combination with the determined electrostatic charge state at the point of incidence. Thus, a set of one or more electron beam parameters (e.g. specific focusing, an acceleration of the electrons, etc.) may have been set by way of a setting of the electron beam device, for example. A certain landing energy can be assumed on the basis of this set. However, said landing energy may have been reduced or increased as a result of the electrostatic charge state determined at the point of incidence. Thus, a corresponding absolute value can be subtracted from the landing energy, or a corresponding absolute value can be added, on the basis of the electrostatic charge state.

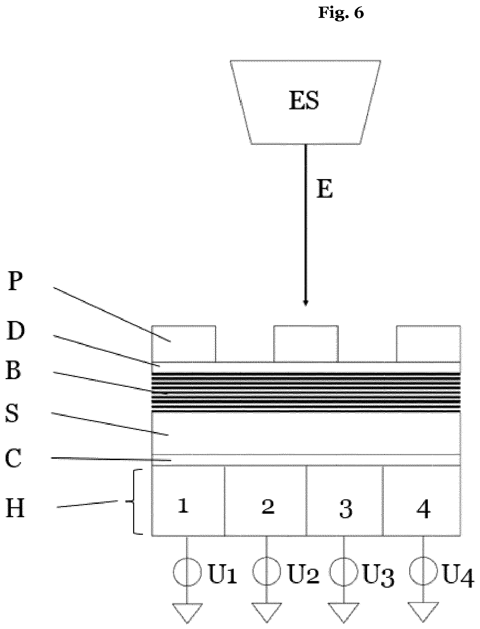

Fig. 6 schematically shows a further example of the aspects described herein, in which a sample is processed and/or examined using a particle beam, wherein the application of voltage to the element comprises an application of segment-specific voltages to different segments of the element. The sample in Fig. 6 comprises an EUV mask 100, as described for Fig. 4**.** The EUV mask 100 is likewise processed and/or examined using an electron beam E, which emanates from an electron beam source ES.

However, the mount H in Fig. 6 differs from that in Fig. 4**.** Thus, the mount H in Fig. 6 comprises two or more segments, to each of which a segment-specific voltage can be applied on the basis of the determined electrostatic charge state of the EUV mask 100. For example, a segment-specific voltage can be applied to a first segment 1 of the mount H by way of a first voltage source U1. For example, a segment-specific voltage can be applied to a second segment 2 by way of a second voltage source U2. For example, a segment-specific voltage can be applied to a third segment 3 by way of a third voltage source U3. For example, a segment-specific voltage can be applied to a fourth segment 4 by way of a fourth voltage source U3. The mount H might also comprise more than four segments, but these have not been depicted in this schematic illustration.

The mount in Fig. 6 can enable a spatially dependent biasing of the EUV mask 100 for the method described herein. The segment-specific voltages allow corresponding segment-specific electric fields to be created, and these can act on different regions of the EUV mask 100. As described herein, the segments can also be referred to as pixels, with a pixel being able to influence a corresponding surface region (a corresponding surface pixel) of the EUV mask 100 by way of its electric field.

For example, the spatially dependent biasing might be useful if the electrostatic charge state differs at different locations on the EUV mask 100 (or on a sample more generally). For example, this might be the case for EUV masks whose conductive regions do not always pass all the way through in certain regions of the mask surface. An electrostatic charge state that differs at different locations may be present in the case of DUV masks (for DUV lithography) e.g. for the same reasons. Spatially dependent biasing may therefore be particularly advantageous for e.g. EUV masks and/or DUV masks.

For example, the electron beam E might be directed at a first region of the EUV mask 100 during the processing and/or examination. For example, the corresponding position of the particle beam on the EUV mask can be specified as X1, Y1. For example, the position X1, Y1 can also be a position on a surface region of the EUV mask 100 at which the electron beam is incident. An electrostatic charge state can be determined for this position (and/or the first region). It is subsequently possible to determine, for segments of the mount, the voltage that needs to be applied to influence the electron beam in the first region such that the desired landing energy is obtained. Subsequently, voltage can be applied accordingly such that the desired landing energy is present. As a result, the landing energy of the electrons at the position X1, Y1 can be set locally to a desired value.

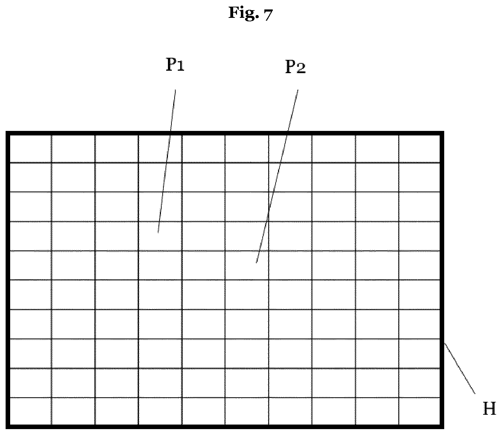

Fig. 7 schematically shows a plan view of a further example of a segmented mount for holding a sample in a device according to the disclosure described herein. Figure 7 illustrates an exemplary segmented mount H which comprises a plurality of segments in the form of pixels, to each of which a pixel-specific voltage can be applied. For example, a first pixel P1 and a second pixel P2 are highlighted. As mentioned, the EUV mask can be subdivided into surface regions that can be referred to as surface pixels (e.g. the surface pixel at the position X1, Y1 of the EUV mask 100). If the EUV mask is affixed by way of the mount H, then one or more pixels of the mount H can be assigned to a surface pixel of the EUV mask. During processing, the electron beam E, for example, is directed at a location within a first surface pixel at the position X1, Y1. The first surface pixel can also be considered to be the first region of the sample (as described herein). For example, the first pixel P1 of the mount H can be assigned to this first surface pixel at the position X1, Y1 of the EUV mask. The electrostatic charge state can be determined within the scope of the method for the first surface pixel. Subsequently, a segment-specific voltage can be applied to the first pixel P1, for the desired adjustment of the landing energy of the electron beam in the first surface pixel at the position X1, Y1 (as described herein).

However, the various local electrostatic charge states of the EUV mask 100 may lead to an electric field emanating from a second surface pixel of the EUV mask, and this electric field interferes with the electron beam E incident in the first surface pixel. The second surface pixel can also be considered to be the second region of the sample (as described herein). This interference from the second surface pixel can be purposefully compensated by way of the segmented mount H. Thus, for example, an electrostatic charge state can be determined for a second surface pixel at the position X2, Y2 of the EUV mask. It is subsequently possible to determine, for pixels of the mount H (e.g. for a second pixel P2), the voltage that must be applied such that the interfering effect from the second surface pixel on the electron beam in the first surface pixel can be avoided. Subsequently, the appropriate application of voltage can be implemented at the pixel (e.g. the second pixel P2) such that the interference from the second surface pixel is reduced (or rectified).

In summary, it is thus possible to avoid interfering electric fields which arise due to local electrostatic charging in the surroundings of the position X2, Y2 of the EUV mask and pass over to the spatial position X1, Y1 of the EUV mask. At the same time, the electron beam can be made to have the desired landing energy at the position X1, Y1. In the mentioned example, a segment-specific voltage would be applied to the first pixel P1 for the purpose of modulating the landing energy of the electron beam E incident on the EUV mask on the first surface pixel (at the position X1, Y1). A segment-specific voltage would be applied to the second pixel P2 for the purpose of compensating an interfering electric field emanating from the second surface pixel (at the position X2, Y2) of the EUV mask.

Further, a segment-specific voltage for adjusting the landing energy of the electrons can also be applied to a plurality of segments (or pixels) of the mount H. Further, segment-specific voltages for compensating one or more local electric interference fields emanating from the EUV mask 100 (e.g. from different surface pixels) can also be applied to a plurality of segments (or pixels) of the mount H.

In general, multi-pole fields can be created by the two or more segments of the mount H, and these can be used in the method described herein for the purpose of implementing the spatially dependent biasing.

The spatially dependent biasing can likewise be repeated dynamically over the course of the processing and/or examination since the local electrostatic charge state may change dynamically.

By way of example, the following steps are listed in this respect, these steps being able to be implemented during the method while processing and/or examining the EUV mask using the electron beam E.

In a first step, the charge state can be determined at at least one position on the EUV mask 100 (e.g. X1, Y1; X2, Y2; ...; Xn, Yn). For example, this can be determined on the basis of reference structures (e.g. by determining scale factors). For example, one or more repair steps might have already been carried out using the electron beam E, with the result that an electrostatic charge state is present.

In a second step, it is possible to determine the segment-specific voltages (e.g. U1, U2, ..., Un) that have to be applied to the two or more segments of the mount in order to compensate, at the determined positions (e.g. X1, Y1; ... Xn, Yn), the local electric fields caused by the electrostatic charge state and/or in order to bring about the desired landing energy at a specific position on the EUV mask 100. For example, the determination of the segment-specific voltages can be based on a model calculation. For example, a finite element method calculation may be implemented to this end, wherein the model may comprise a simulation model of the mount H (and e.g. of a sample as well). For example, the calculation allows a derivation of to what extent the segment-specific voltages need to be applied in order to obtain a desired effect. For example, the simulation might be predetermined and need not necessarily be carried out during the repair.

In a third step, the previously determined segment-specific voltages can be applied to the segments of the mount H, with the result that the local electric fields are compensated and/or the desired landing energy is present. This step can also be referred to as e.g. compensation step.

The first, second and third step can be repeated multiple times in the method in order to take account of a change in the electrostatic charge state during the method. It is self-evident that further processes within the scope of the method (e.g. using the electron beam E) can be carried out before, after or between these steps.

In summary, the segment-specific voltages can be applied dynamically on the basis of the repeated determination of the (e.g. local or global) electrostatic charge states of the EUV mask 100 present, even for a mount with two or more segments.

In an example, the method described herein using the electron beam can be implemented in such a way that when the mask is processed and/or examined using the electron beam, it is possible to ensure that a minimal repair size of the mask is better than 12 nm. For example, excess material may protrude from a pattern element A. For example, in relation to an intended edge of the pattern element A, a certain length of excess material may protrude therefrom. For a repair, this excess material must be removed as far as the target edge, in order to repair the pattern element. The minimal repair size may e.g. comprise the length of the excess material from the target edge, from where it is possible to ensure that the removal of this excess material during the repair leads to correction of the pattern element (or mask). As a result of the method described herein which takes account of the electrostatic charge state of the mask, it is e.g. possible to also remove very delicate protrusions, which e.g. protrude from the pattern element by between 5 nm and 12 nm, using the electron beam such that the mask is repaired.

In an example, the method described herein using the electron beam can be implemented in such a way that when the mask is processed by the electron beam, it is possible to ensure that a minimal repair size of the mask is better than 15 nm, preferably better than 12 nm or even better than 11 nm. For example, this may be the case with silicon nitride-based masks. In an example, the method described herein using the electron beam can be implemented in such a way that when the mask is processed using the electron beam, it is possible to ensure that a minimal repair size of the mask is better than 10 nm. For example, this may be the case with tantalum nitride-based masks.

### Further embodiments

1. Method for processing and/or examining a sample (100) using a particle beam (E), including the following steps:
   determining an electrostatic charge state of the sample (100);
   applying a voltage to an element (H) in surroundings of the sample, based at least in part on the determined electrostatic charge state.
2. Method according to embodiment 1, wherein the application of voltage causes an electric field at a point of incidence of the particle beam (E) on the sample (100).
3. Method according to either of embodiments 1 and 2, wherein the application of voltage is implemented such that this influences a landing energy of particle beam particles on the sample.
4. Method according to embodiment 3, wherein the application of voltage is implemented such that the landing energy is within a first predetermined value range.
5. Method according to any of embodiments 1-4, wherein the application of voltage is implemented such that the electrostatic charge state of the sample is at least partly compensated.
6. Method according to embodiment 5, wherein the application of voltage causes the electrostatic charge state to be within a second predetermined value range.
7. Method according to any of embodiments 1-6, wherein the steps according to Claim 1 are repeated at least once.
8. Method according to any of embodiments 1-7, wherein the element is arranged on an underside of the sample located opposite a top side of the sample from which the particle beam is directed at the sample during the processing and/or examination.
9. Method according to embodiment 8, wherein at least a partial area of the sample is in contact with the element when voltage is applied.
10. Method according to embodiment 8 or 9, wherein the element comprises a mount for holding the sample.
11. Method according to embodiment 10, wherein the mount comprises a base area which is in contact with the sample during the method.
12. Method according to any of embodiments 1-11, wherein the element (H) comprises two or more segments, the application of voltage comprising:
   applying a first voltage to a first segment (1, P1) of the element (H);
   applying a second voltage to a second segment (2, P2) of the element (H).
13. Method according to embodiment 12, wherein the application of the first and second voltage is implemented for the purpose of influencing the processing and/or examination of the sample in a first region of the sample.
14. Method according to embodiment 13, wherein the application of the first voltage causes the landing energy of particle beam particles in the first region to be influenced.
15. Method according to either of embodiments 13 and 14, wherein the determination of the electrostatic charge state comprises: determining an electrostatic charge state in a second region differing from the first region, the application of the second voltage being based at least in part on the electrostatic charge state determined in the second region.
16. Method according to embodiment 15, wherein the application of the second voltage causes the suppression of an electric field emanating from the second region.
17. Method according to any of embodiments 1-16, wherein the method is performed for the purpose of processing and/or examining a lithography object.
18. Computer program for executing a method according to any of embodiments 1-17.
19. Device for processing and/or examining a sample (100) using a particle beam (E), comprising:
   determination means for determining an electrostatic charge state of the sample;
   an element (H) arranged in surroundings of the sample when the sample is arranged in a sample position in the device;
   application means for applying a voltage to the element (H), based at least in part on the determined electrostatic charge state.
20. Device according to embodiment 19, wherein arrangement of the sample (100) in the sample position leads to the element (H) being arranged on an underside of the sample (100) located opposite a top side of the sample (100) from which the particle beam (E) is directed at the sample (100) during the processing and/or examination.
21. Device according to embodiment 20, wherein the device is configured such that at least a partial area of the underside of the sample (100) is in contact with the element (H) when voltage is applied.
22. Device according to any of embodiments 19-21, wherein the element comprises a mount for holding the sample.
23. Device according to embodiment 22, wherein the mount (H) comprises a base area which is in contact with the underside of the sample (100) when the sample is arranged in the sample position.
24. Device according to any of embodiments 19-23, wherein the element (H) comprises two or more segments, wherein a first voltage can be applied to a first segment (1, P1) and a second voltage can be applied to a second segment (2, P2) of the element by means of the application means.

## Claims

1. Method for processing and/or examining a sample (100) using a particle beam (E), including the following steps:
determining an electrostatic charge state of the sample (100);
applying a voltage to an element (H) in surroundings of the sample, based at least in part on the determined electrostatic charge state;
wherein:
the element (H) comprises two or more segments; and/or
the element (H) is movable relative to the sample (100).

2. Method according to Claim 1, wherein the application of voltage causes an electric field at a point of incidence of the particle beam (E) on the sample (100).

3. Method according to either of Claims 1 and 2, wherein the application of voltage is implemented such that this influences a landing energy of particle beam particles on the sample, preferably wherein the application of voltage is implemented such that the landing energy is within a first predetermined value range.

4. Method according to any of Claims 1-3, wherein the application of voltage is implemented such that the electrostatic charge state of the sample is at least partly compensated, preferably wherein the application of voltage causes the electrostatic charge state to be within a second predetermined value range.

5. Method according to any of Claims 1-4, wherein the steps according to Claim 1 are repeated at least once.

6. Method according to any of Claims 1-5, wherein the element is arranged on an underside of the sample located opposite a top side of the sample from which the particle beam is directed at the sample during the processing and/or examination, preferably wherein at least a partial area of the sample is in contact with the element when voltage is applied.

7. Method according to Claim 6, wherein the element comprises a mount for holding the sample, preferably wherein the mount comprises a base area which is in contact with the sample during the method.

8. Method according to any of Claims 1-7, wherein the element (H) comprises two or more segments, the application of voltage comprising:
applying a first voltage to a first segment (1, P1) of the element (H);
applying a second voltage to a second segment (2, P2) of the element (H).

9. Method according to Claim 8, wherein the application of the first and second voltage is implemented for the purpose of influencing the processing and/or examination of the sample in a first region of the sample, preferably wherein the application of the first voltage causes the landing energy of particle beam particles in the first region to be influenced.

10. Method according to Claim 9, wherein the determination of the electrostatic charge state comprises:
determining an electrostatic charge state in a second region differing from the first region, the application of the second voltage being based at least in part on the electrostatic charge state determined in the second region, preferably wherein the application of the second voltage causes the suppression of an electric field emanating from the second region.

11. Method according to any of Claims 1-10, wherein the method is performed for the purpose of processing and/or examining a lithography object.

12. Computer program for executing a method according to any of Claims 1-11.

13. Device for processing and/or examining a sample (100) using a particle beam (E), comprising:
determination means for determining an electrostatic charge state of the sample;
an element (H) arranged in surroundings of the sample when the sample is arranged in a sample position in the device;
application means for applying a voltage to the element (H), based at least in part on the determined electrostatic charge state;
wherein:
the element (H) comprises two or more segments; and/or
the element (H) is movable relative to the sample (100).

14. Device according to Claim 13, wherein arrangement of the sample (100) in the sample position leads to the element (H) being arranged on an underside of the sample (100) located opposite a top side of the sample (100) from which the particle beam (E) is directed at the sample (100) during the processing and/or examination, preferably wherein the device is configured such that at least a partial area of the underside of the sample (100) is in contact with the element (H) when voltage is applied.

15. Device according to either of Claims 13 and 14, wherein the element comprises a mount for holding the sample, preferably wherein the mount (H) comprises a base area which is in contact with the underside of the sample (100) when the sample is arranged in the sample position.

16. Device according to any of Claims 13-15, wherein the element (H) comprises two or more segments, wherein a first voltage can be applied to a first segment (1, P1) and a second voltage can be applied to a second segment (2, P2) of the element by means of the application means.
